**Europäisches Patentamt**

**European Patent Office**

**Office européen des brevets**

(19)

(11) Numéro de publication : **0 595 719 A1**

## (12) DEMANDE DE BREVET EUROPEEN

(21) Numéro de dépôt : **93402638.6**

(22) Date de dépôt : **27.10.93**

(51) Int. Cl.$^5$ : **G06F 15/60,** G06F 15/419, G06F 15/36

(30) Priorité : **30.10.92 FR 9213011**

(43) Date de publication de la demande :
**04.05.94 Bulletin 94/18**

(84) Etats contractants désignés :
**AT BE CH DE DK ES FR GB GR IE IT LI LU NL PT SE**

(71) Demandeur : **BULL S.A.
Tour BULL, 1, place Carpeaux
F-92800 Puteaux (FR)**

(72) Inventeur : **Coudert, Olivier
75bis, rue de Paris
F-92100 Boulogne Billancourt (FR)**
Inventeur : **Madre, Jean-Christophe
4, rue des Longs Prés
F-92100 Boulogne Billancourt (FR)**

(74) Mandataire : **Denis, Hervé et al
BULL S.A. Tour BULL Cédex 74 PC/TB2803
F-92039 Paris La Défense (FR)**

(54) **Procédé de détermination automatique des probabilités associées à une fonction booléenne.**

(57)    L'invention est relative à un procédé qui permet de calculer automatiquement, et de façon exacte, les probabilités associées à une fonction booléenne.

Selon l'invention, la probabilité d'un événement représenté par une fonction booléenne (f) est déterminée en constituant le diagramme de décision binaire de cette fonction et en effectuant des parcours récursifs au travers de ce diagramme.

Fig. 1

**EP 0 595 719 A1**

L'invention est relative à un procédé pour déterminer automatiquement, à l'aide d'une machine de traitement de données, les probabilités associées à une fonction booléenne.

Les fonctions booléennes sont manipulées dans de nombreux domaines. A titre d'exemple, la synthèse, l'optimisation de circuits électroniques, l'analyse des défaillances des systèmes peuvent utiliser la manipulation de fonctions booléennes.

Ainsi, par exemple, dans l'analyse de défaillances, la survenance d'une défaillance en fonction des événements extérieurs susceptibles de provoquer cette défaillance, peut être analysée à l'aide d'une fonction booléenne.

Plus généralement, dans tout système, la survenance d'un événement de référence, ou d'une action, lorsqu'elle est fonction d'un ou plusieurs événements concomitants, encore appelés événements microscopiques, peut être ainsi analysée. Chaque événement microscopique est donc une variable de la fonction.

Pour la compréhension de la suite, il convient de rappeler quelques notions et définitions relatives aux fonctions booléennes, et la terminologie employée.

Supposons une fonction booléenne f définie par la formule suivante: $f = x_1 x_2^* + x_1^* x_2 x_3$. On dit que la formule est une formule propositionnelle, et que $x_1$, $x_2$, $x_3$ sont des variables propositionnelles, correspondant aux événements atomiques susceptibles de provoquer l'apparition de l'événement de référence noté f, et donné par la formule.

Ainsi, dans l'analyse de défaillances de systèmes, les événements atomiques sont des causes de défaillance, et l'événement de référence est une défaillance particulière liée à ces causes combinées entre elles de certaines manières.

Les termes "$x_1$", "$x_2$", "$x_3$" et "$x_1^*$", "$x_2^*$", "$x_3^*$", qui apparaissent dans la formule sont des littéraux correspondant aux variables propositionnelles $x_1$, $x_2$, $x_3$. Un littéral représente comment la variable propositionnelle intervient dans la fonction, c'est-à-dire si la survenance ou la non survenance de l'événement associé est décisive ou indifférente. $x_1 x_2^*$ et $x_1^* x_2 x_3$ sont des produits de littéraux. Un produit est donc une conjonction de variables et de négations de variables.

Le premier produit $x_1 x_2^*$ signifie que la présence ou l'absence de la troisième variable $x_3$ est indifférente.

La formule signifie que l'événement de référence survient (f=1) quand simultanément le premier événement atomique $x_1$ survient ($x_1 = 1$) et le second $x_2$ ne survient pas ($x_2 = 0$), ou bien quand simultanément le premier événement $x_1$ ne survient pas et les second et troisième $x_2$ et $x_3$ surviennent.

En fait une telle formule résulte soit d'une simulation, soit d'une analyse effectuée sur un prototype.

Dans l'analyse d'un système (fonctionnement ou défaillance) une telle formule est habituellement présentée sous forme d'un tableau qui montre les différents produits de la fonction. Ainsi, le tableau associé à la fonction donnée en exemple contiendrait les produits $x_1 x_2^*$ et $x_1^* x_2 x_3$.

Un tel tableau est appelé arbre de défaillances dans le cadre de l'analyse des défaillances d'un système. Plus généralement, on peut l'appeler arbre événementiel.

Un tel arbre peut être utilisé pour effectuer diverses analyses ou calculs relatifs au comportement du système. En particulier, on peut envisager de calculer la probabilité de survenance d'un événement de référence en fonction de celle de chacun des événement atomiques.

A cet effet, le tableau donne non seulement les produits contribuant à la survenance de la fonction, mais encore le probabilité de survenance de chaque événement atomique. Cette probabilité a été déterminée par exemple lors de la simulation ou de l'analyse.

Néanmoins, le calcul de probabilité de chaque événement de référence, tel qu'une défaillance, doit être effectué postérieurement à cette analyse ou simulation. Ce calcul doit être automatisé car, soit le tableau comporte un nombre extrêmement important de produits, soit il faut analyser un nombre important d'événements de référence.

Or, les méthodes connues jusqu'alors ne donnent pas satisfaction. En effet, elles partent de formules d'approximation qui nécessitent le calcul des impliquants de la fonction.

On rappelle qu'un impliquant d'une fonction est un produit qui implique cette fonction. On rappelle encore qu'un premier produit P "contient" un second produit P', si la relation P "implique" P' (ceci s'écrit P= >P') est vraie, et enfin un impliquant premier est un impliquant tel qu'il n'existe pas d'autre impliquant qui le contienne.

L'utilisation de formules d'approximation ne permet pas d'aboutir à un résultat exact. Par ailleurs, ce calcul approché nécessite un appareil de traitement avec une importante capacité de calcul et de mémorisation car il faut calculer et stocker ces impliquants, de même qu'il faut calculer et stocker nombre de résultats intermédiaires, issus de ces calculs approximatifs sur les impliquants, afin de combiner par la suite ces impliquants ou ces résultats intermédiaires pour obtenir le résultat final.

Les buts de l'invention sont donc d'obtenir un procédé qui permette d'obtenir automatiquement la probabilité exacte d'un événement de référence, sans nécessiter de capacités de mémorisation importantes.

Selon l'invention, un procédé pour déterminer automatiquement, à l'aide d'une machine de traitement de données, la probabilité d'un événement de référence dépendant d'événements atomiques combinés entre eux, chaque événement atomique ayant une probabilité de survenance connue par avance, est caractérisé en ce qu'il consiste à élaborer le diagramme de décision binaire correspondant à la fonction représentative de l'événement de référence et à parcourir récursivement ce diagramme pour obtenir la probabilité P(f) de l'événement de référence par application de la formule P(f) = (1 - p($x_1$)) . p(L) + p($x_1$) . p(H) dans laquelle p($x_1$) est la probabilité connue par avance de l'événement racine des diagrammes et p(L) et p(H) sont respectivement les probabilités de la branche négative et de la branche positive de l'arbre, ces dernières étant obtenues au fur et à mesure des parcours récursifs effectués sur le diagramme de décision binaire.

De façon connue, un graphe ou diagramme de décision binaire est constitué d'un certain nombre de labels, encore appelés étiquettes, reliés entre eux par des branches. Chaque label représente une variable déterminée de la fonction, d'où partent deux branches. L'ensemble constitué par un label, donc une variable, et les deux branches qui en partent constitue un noeud, parfois appelé vertex. Chaque branche peut être soit une branche terminale, qui aboutit sur une feuille terminale de valeur "0" ou "1", ou une branche intermédiaire qui aboutit sur le label d'un autre noeud. L'une des branches qui part d'un label est appelée la branche basse ou négative et représente ce qui se passe lorsque la valeur de la variable associée est "0" (en utilisant les conventions rappelées ci-avant), alors que l'autre branche, appelée la branche haute ou positive montre ce qui se passe lorsque la valeur de la variable est "1". En fait, l'arbre débute par une variable (un label) racine unique, appelée la racine, d'ou partent deux branches auxquelles sont reliées en cascade d'autres noeuds ou des feuilles.

En parcourant l'arbre depuis la racine jusqu'à une feuille terminale de valeur 1, on détermine une combinaison de littéraux, pour laquelle la fonction vaut 1, c'est-à-dire qu'on reconstitue une combinaison (un produit) de variables provoquant l'apparition de l'événement de référence représenté. En conséquence, en effectuant chacun des parcours depuis la racine jusqu'à chacune des feuilles terminales de valeur 1, on détermine chacune des combinaisons de variables provoquant l'apparition de l'événement de référence.

Un tel diagramme ou graphe permet donc de visualiser l'ensemble des combinaisons de variables d'une fonction, de façon extrêmement complète et concise. La place mémoire occupée est moindre par rapport aux tableaux, et les temps de traitement des fonctions représentées sous forme de graphes de décision binaire sont beaucoup plus rapides.

Différentes approches des diagrammes de décision binaire ont été envisagées. Ainsi Randal E. Bryant, dans une publication parue dans "IEEE Transactions on Computers", Volume C-35, numéro 8, Août 1986, a montré comment on pouvait ordonner les variables et donc les noeuds, pour aboutir à des graphes extrêmement compacts mais parfaitement représentatifs des différentes combinaisons de variables apparaissant dans une fonction.

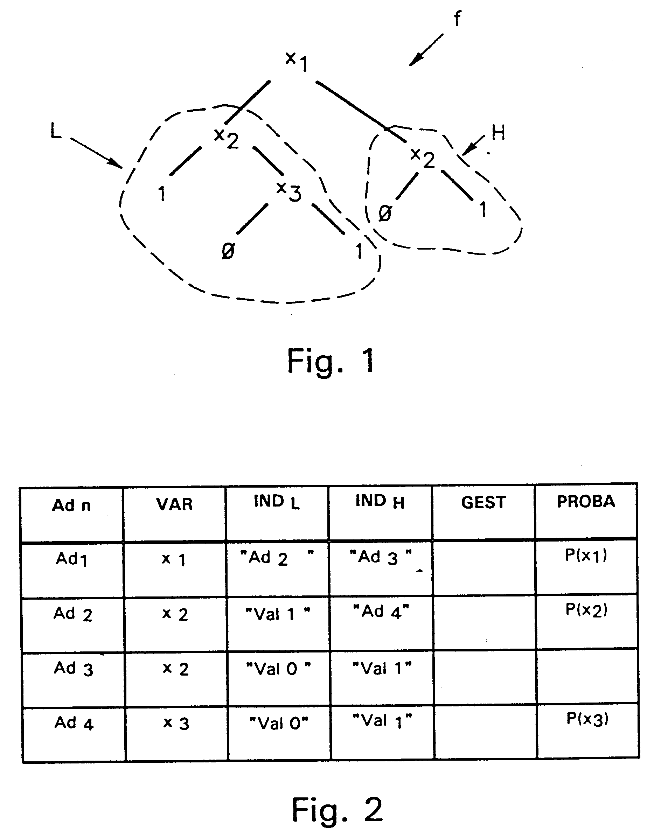

Sur la figure 1, on a représenté un diagramme de décision binaire d'une fonction booléenne dans laquelle apparaissent trois variables propositionnelles $x_1$, $x_2$, $x_3$.

Dans l'exemple illustré sur cette figure 1, une première variable, identifiée par un label $x_1$, est la racine du graphe. De cette variable partent deux branches, une première branche en bas à gauche et une seconde branche en bas à droite. La branche de gauche est appelée la branche basse, alors que la branche droite est appelée la branche haute. L'ensemble racine, branches basse et haute constitue donc un premier noeud du diagramme.

La branche basse et la branche haute aboutissent chacune sur une seconde variable identifiée par un label $x_2$. A cette seconde variable est également associée une branche basse et une branche haute, ce qui constitue un autre noeud.

L'ensemble de labels (ou de variables), de branches, de feuilles associé à une branche basse d'une autre variable constitue ce que l'on appellera par la suite la partie basse notée L de cette variable. L'ensemble associé à la branche haute d'une variable constitue la partie haute, notée H de cette variable.

Ainsi, la partie haute de la variable $x_1$ débute par un noeud dont la racine est la variable $x_2$, la partie basse est la feuille 0 et la partie haute une feuille de valeur 1.

En parcourant les branches de l'arbre à partir de la racine en direction des feuilles de valeur "1", on détermine que la fonction représentée vaut 1 lorsque:

- $x_2$ vaut 0 et simultanément $x_1$ vaut 0, ou bien;
- $x_1$ vaut 0, et simultanément $x_2$ vaut 1 alors que $x_3$ vaut 1.

Ce qui précède se déduit du parcours des branches basses associées à la racine $x_1$.

Par ailleurs, de la partie haute associée à la racine $x_1$, on déduit que la fonction vaut également 1 lorsque simultanément $x_1$ et $x_2$ valent 1.

En conséquence de ce qui précède, la fonction représentée pourrait s'écrire f=$x_1$* $x_2$* + $x_1$* $x_2$ $x_3$ + $x_1$ $x_2$.

La construction d'un diagramme de décision binaire, tel qu'il est présenté à la figure 1, répond à des règles déterminées et connues qui ne sont pas l'objet de la présente invention. Elles ont été décrites dans la publication mentionnée de Randal E. Bryant.

L'invention exploite donc de façon extrêmement avantageuse le fait que chaque branche haute (positive) ou basse (négative) du diagramme constitue en elle-même un sous-diagramme ayant lui-même ses propres branches haute et basse.

En définitive, la détermination de la probabilité de chaque branche nécessite simplement la mémorisation de la probabilité de chaque sous-branche reliée immédiatement à cette branche. Ainsi, au fur et à mesure des parcours récursifs, il suffit de mémoriser seulement deux valeurs pour déterminer la probabilité de chaque sous-branche, donc au maximum quatre valeurs pour l'ensemble du diagramme.

D'autres caractéristiques et avantage de l'invention apparaitront avec la description qui va suivre, faite en regard des figures 1 et 2 sur lesquelles :

- la figure 1 représente, de façon schématique, le diagramme de décision binaire d'une fonction booléenne (f),
- la figure 2, illustre la façon dont la mémoire d'un appareil de traitement peut être organisée, pour contenir des informations représentatives du diagramme de la figure 1.

La figure 1, et la façon de l'utiliser, ont déjà été commentées en grande partie dans le préambule.

De façon connue et ainsi qu'indiqué , le diagramme de la figure 1 est obtenu à partir d'un tableau ou arbre événementiel, non représenté sur les figures. La détermination du diagramme à partir de ce tableau, qui n'est pas l'objet de la présente invention, s'effectue de façon à optimiser la taille du diagramme pour que le nombre de labels et de branches soit le plus réduit possible.

On constate en définitive que la fonction f illustrée par ce diagramme et dont la formule développée est $f = x_1{}^* x_2{}^* + x_1{}^* x_2 x_3 + x_1 x_2$ peut encore s'écrire, avec les conventions précédemment admises $f = x_1{}^*L + x_1$ H.

L'invention part de cette constatation, et exploite de façon avantageuse le fait que le mode de calcul exact de la probabilité associée à une telle fonction est le suivant : $P(f) = (p(x_1)) . P(L) + P(x_1) . P(H)$, dans lequel $P(a)$ est la probabilité associée à un événement $\underline{a}$, ce qui peut enfin s'écrire $P(f) = [(1-p(x1)) . P(L) + \overline{P}(x1) . P(H)]$.

Or L et H sont des sous-diagrammes dans lesquels les variables $x_2$ et/ou $x_3$ apparaissent. Ainsi, la connaissance préliminaire des probabilités $p(x_1)$, $p(x_2)$, $p(x_3)$ associées à chaque événement microscopique permet, en effectuant des parcours récursifs dans le diagramme, d'obtenir la probabilité globale de l'événement de référence.

La figure 2 illustre comment la mémoire d'un calculateur peut être organisée, pour contenir des informations constituant le diagramme de décision binaire de la fonction représentée sur la figure 1. Ceci n'est absolument pas limitatif.

C'est à partir de ces informations en mémoire que le système de traitement est en mesure de calculer la probabilité de la fonction.

De façon connue, la mémoire est organisée en mots, et chaque mot est déterminé par son adresse absolue ou relative ADn.

Afin de représenter un diagramme de décision binaire, chaque mot peut, par exemple, être divisé en au moins 5 champs, un premier champ VAR, un second champ $IND_L$, un troisième champ $IND_H$, un quatrième champ GEST, et enfin un cinquième champ PROBA.

Le premier champ VAR d'un mot contiendrait une information indiquant la nature et le rang d'une variable propositionnelle de la fonction, par exemple $x_n$.

Le second champ $IND_L$ indiquerait si la branche basse de la variable correspondante aboutit sur un noeud ou sur une feuille.

Le troisième champ $IND_H$ indiquerait si la partie haute de la variable correspondante aboutit sur une feuille ou sur un noeud.

Le quatrième champ GEST contiendrait par exemple des paramètres de gestion nécessaires pour l'exploitation de la mémoire, lorsque des parcours sont effectués entre les différentes adresses.

Plus précisément, le second et le troisième champs pourraient être complétés de la façon suivante: si la branche basse associée à la variable propositionnelle contenue dans le mot aboutit sur une feuille, alors ce second champ contiendrait une indication "Val 0" ou "Val 1" de la valeur de cette feuille comme représenté dans certaines cases de cette figure 2.

Par contre, si la branche basse associée à une variable propositionnelle aboutit sur un noeud, alors ce second champ $IND_L$ contiendrait la valeur de l'adresse mémoire du mot où est inscrit ce noeud.

Le troisième champ $IND_H$ indiquerait, de la même manière que le second champ, si la branche haute associée à une variable aboutit sur un noeud ou sur une feuille et contient le cas échéant une adresse, ou une valeur.

Le quatrième champ GEST contiendrait des paramètres de gestion indiquant les parcours qui ont déjà été effectués, ou tout autre type d'information nécessaire à la gestion et l'exploitation de cette mémoire.

Enfin, le cinquième champ PROBA contiendrait la valeur connue par avance de la probabilité associée à la variable $x_n$ correspondante, indiquée dans le premier champ VAR.

Ainsi, en partant du mot situé à l'adresse $AD_1$, et en parcourant l'ensemble de la mémoire, le système de traitement peut reconstituer les produits pour lesquels la fonction vaut "1". Il est donc en mesure de reconstituer le diagramme de décision et ses différents noeuds.

La détermination des probabilités associées à chaque branche ou sous-branche conduit le système à décomposer des noeuds existants dans le diagramme de décision binaire.

Par convention, dans la suite de la description, une formule du genre Nd(x,L,H)=y décompose le noeud y en sa racine, c'est-à-dire la variable x, en sa branche gauche ou basse L et en sa branche droite ou haute H.

La détermination de la valeur de la probabilité d'un événement dont la fonction f, représentée par un diagramme de décision binaire, peut être obtenue en mettant en oeuvre un algorithme spécifique, que l'on nommera par la suite "GET PROBA (f)" qui met en oeuvre les étapes suivantes :

Un test est d'abord réalisé pour déterminer la nature de la fonction.

Si f=0 alors GETPROBA(f)=0, si f=1 alors GETPROBA(f)=1;

Si f est différent de 0 ou de 1 ce qui signifie que f se présente sous la forme d'un noeud ayant une racine $x_k$, un branche basse L et une branche haute H, alors une décomposition du noeud est effectuée, puis la fonction "GETPROBA" met alors en oeuvre l'instruction suivante :

GETPROBA = (1 - GETELEMENTARYPROBA $(x_k)$) · GETPROBA(L) + GETELEMENTARYPRO-BA$(x_k)$ · GETPROBA(H),

dans laquelle "GETELEMENTARYPROBA$(x_k)$" est une instruction dont l'exécution consiste à lire la valeur de la probabilité associée à la variable $(x_k)$, dans le cinquième champ "PROBA", et à l'incorporer dans le calcul.

On constate par ailleurs que l'instruction "GETPROBA" est récursive, puisqu'elle nécessite le calcul des probabilités associées aux branches basse L et haute H, en se faisant appel à elle-même. En conséquence, le calcul débute toujours en partant de noeuds terminaux de l'arbre, c'est-à-dire de noeuds dont les branches basses et hautes aboutissent sur des feuilles terminales ayant pour valeur 0 et 1 ou réciproquement.

On constate par contre que, contrairement à l'art antérieur, l'algorithme employé permet de déterminer de façon exacte la valeur de la probabilité associée à un événement déterminé, puisqu'aucune simplification ou approximation n'est nécessaire lors du calcul.

Par ailleurs, la consommation mémoire est minime. Il suffit de prévoir, dans la mémoire de l'appareil de traitement une mémoire tampon, dont le contenu est modifié à chaque récursion, et qui contient, lors du calcul de la probabilité associée à un label, la probabilité, obtenue par mise en oeuvre de la fonction "GETPROBA", de chaque branche haute et basse reliée à ce label.

**Revendications**

1. Procédé pour déterminer automatiquement, à l'aide d'une machine de traitement de données, la probabilité d'un événement de référence dépendant d'événements atomiques combinés entre eux, chaque événement atomique ayant une probabilité de survenance connue par avance, caractérisé en ce qu'il consiste à élaborer le diagramme de décision binaire (f) correspondant à la fonction booléenne représentative de l'événement de référence et à parcourir récursivement ce diagramme pour obtenir la probabilité P(f) de l'événement de référence par application de la formule P(f) = (1 - p($x_1$)) . p(L) + p($x_1$) . p(H) dans laquelle p($x_1$) est la probabilité connue par avance de l'événement racine des diagrammes et p(L) et p(H) sont respectivement les probabilités de la branche négative et de la branche positive de l'arbre, ces dernières étant obtenues au fur et à mesure des parcours récursifs effectués sur le diagramme de décision binaire.

2. Procédé selon la revendication 1, caractérisé en ce que la probabilité p(f) d'un événement (f) est obtenue par mise en oeuvre d'une fonction (GET PROBA(f)) qui comporte une phase de test au cours de laquelle il est déterminé si l'événement (f) possède une valeur finie (O ou 1) ou constitue un noeud Nd($x_k$,L,H) dans lequel $x_k$ est un label ou une variable racine représentatif d'un événement atomique , L et H sont respectivement les branches basse et haute associées à ce label.

3. Procédé selon la revendication 2, caractérisé en ce que la fonction (GETPROBA(f)) est telle que s'il est déterminé que la valeur de f est 1, la valeur de la probabilité P(f) associée rendue par la fonction est 1.

4. Procédé selon la revendication 2, caractérisé en ce que la fonction (GETPROBA(f)) est telle que s'il est déterminé que la valeur de f est 0, la valeur de la probabilité P(f) associée rendue par la fonction est 0.

5. Procédé selon la revendication 2, caractérisé en ce que s'il est déterminé que l'événement (f) constitue un noeud, la fonction (GETPROBA(f)) consiste à décomposer le noeud en son label ($x_k$), sa branche basse (L) et sa branche haute (H) et à rendre le résultat suivant :

P(f) = (1 - GETELEMENTARYPROBA $(x_k)$ x GETPROBA (L) + GETELEMENTARYPROBA $(x_k)$ * GETPROBA (H)

dans lequel GETELEMENTARYPROBA (xk) est une fonction qui permet de retrouver la valeur P(xk) de la probabilité associée, connue par avance, du label sk.

6. Procédé selon l'une des revendications précédentes caractérisé en ce que la probabilité P($x_k$) d'un événement atomique ($x_k$) est obtenue à partir d'un arbre événementiel ayant servi à élaborer le diagramme de décision binaire.

7. Procédé selon la revendication 6, caractérisé en ce que, lors de l'élaboration du diagramme de décision binaire, la probabilité (P($x_k$)) de chaque événement atomique est mémorisée en regard de ce diagramme, à partir de l'arbre événementiel.

8. Application du procédé selon l'une des revendications 1 à 7 au calcul de probabilités dans l'analyse de défaillances d'un système.

## Fig. 1

| Ad n | VAR | IND L | IND H | GEST | PROBA |
|---|---|---|---|---|---|
| Ad 1 | x 1 | "Ad 2 " | "Ad 3 " | | $P(x_1)$ |
| Ad 2 | x 2 | "Val 1 " | "Ad 4" | | $P(x_2)$ |
| Ad 3 | x 2 | "Val 0 " | "Val 1" | | |
| Ad 4 | x 3 | "Val 0" | "Val 1" | | $P(x_3)$ |

## Fig. 2

**Office européen des brevets**

**RAPPORT DE RECHERCHE EUROPEENNE**

Numero de la demande

EP 93 40 2638

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| P,X | RELIABILITY ENGINEERING & SYSTEM SAFETY, ELSEVIER APPLIED SCIENCE LTD vol. 40 , 1993 , ENGLAND pages 203 - 211 ANTOINE RAUZY 'NEW ALGORITHMS FOR FAULT TREES ANALYSIS' * page 209, colonne de droite, ligne 7 - page 210, colonne de gauche, ligne 4 * | 1-8 | G06F15/60 G06F15/419 G06F15/36 |
| X | PROCEEDINGS OF THE ANNUAL SYMPOSIUM ON RELIABILITY AND MAINTAINABILITY, IEEE PRESS NEW YORK, US 21 Janvier 1992 , LAS VEGAS, NEVADA, US pages 370 - 375 XP000273440 W.G.SCHNEEWEISS 'APPROXIMATE FAULT-TREE ANALYSIS WITHOUT CUT SETS' * page 370, colonne de droite, ligne 30 - page 371, colonne de gauche, ligne 11 * | 1-8 | |
| X | IEEE TRANSACTIONS ON RELIABILITY, IEEE PRESS vol. 41, no. 3 , Septembre 1992 , NEW YORK, US pages 343 - 351 W.G.SCNEEWEISS 'RELIABILITY THEORY FOR LARGE LINEAR SYSTEMS WITH HELPING NEIGHBORS' * page 344, colonne de gauche, ligne 20 - colonne de droite, ligne 10 * * page 346, colonne de droite, ligne 14 - page 347, colonne de gauche, ligne 25 * | 1-8 | **DOMAINES TECHNIQUES RECHERCHES (Int.Cl.5)** G06F |

-/--

Le présent rapport a été établi pour toutes les revendications

| Lieu de la recherche | Date d'achèvement de la recherche | Examinateur |
|---|---|---|
| LA HAYE | 15 Décembre 1993 | Barba, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

**Office européen**

**des brevets**

**RAPPORT DE RECHERCHE EUROPEENNE**

Numero de la demande

EP 93 40 2638

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| A | IBM TECHNICAL DISCLOSURE BULLETIN vol. 14, no. 11 , Avril 1972 pages 3521 - 3522 K.KOCH 'REPRESENTATION OF TREE DATA STRUCTURES FOR DATA MANIPULATION AND SEARCH OPERATIONS' * le document en entier * ----- | 1-8 | |
| | | | **DOMAINES TECHNIQUES RECHERCHES (Int.Cl.5)** |

Le présent rapport a été établi pour toutes les revendications

| Lieu de la recherche | Date d'achèvement de la recherche | Examinateur |
|---|---|---|
| LA HAYE | 15 Décembre 1993 | Barba, M |

EPO FORM 1503 03.82 (P04C02)